Europäisches Patentamt

European Patent Office

Office européen des brevets

(11) Numéro de publication: **0 435 397 A1**

## (12) DEMANDE DE BREVET EUROPEEN

(21) Numéro de dépôt: 90203409.9

(22) Date de dépôt: 18.12.90

(51) Int. Cl.⁵: **G01J 5/34, H01L 37/02**

(30) Priorité: 29.12.89 FR 8917454

(43) Date de publication de la demande:
**03.07.91 Bulletin 91/27**

(84) Etats contractants désignés:
**DE FR GB IT**

(71) Demandeur: **LABORATOIRES
D'ELECTRONIQUE PHILIPS
22, avenue Descartes, BP 15
F-94453 Limeil-Brévannes Cédex(FR)**
(84) **FR**

Demandeur: **N.V. Philips'
Gloeilampenfabrieken
Groenewoudseweg 1
NL-5621 BA Eindhoven(NL)**
(84) **DE GB IT**

(72) Inventeur: **Baudry, Hughes**

**Société Civile S.P.I.D., 156 Boulevard
Haussmann
F-75008 Paris(FR)**
Inventeur: **Delmas, Gilles
Société Civile S.P.I.D., 156 Boulevard
Haussmann
F-75008 Paris(FR)**
Inventeur: **Ongaretti, Sylvie
Société Civile S.P.I.D., 156 Boulevard
Haussmann
F-75008 Paris(FR)**
Inventeur: **Jean, Claude
Société Civile S.P.I.D., 156 Boulevard
Haussmann
F-75008 Paris(FR)**

(74) Mandataire: **Landousy, Christian et al
Société Civile S.P.I.D. 156, Boulevard
Haussmann
F-75008 Paris(FR)**

(54) **Elément détecteur pyroélectrique et dispositifs pour la détection de phénomènes thermiques.**

(57) Elément détecteur pyroélectrique ($P_1$, $P_2$...), comprenant sur un substrat (10) une couche du type sérigraphié d'un matériau céramique piézoélectrique (3) disposée entre deux couches du type sérigraphié de matériaux conducteurs constituant des électrodes (2,4), caractérisé en ce qu'entre la première couche (2) de matériau conducteur et le substrat, (10), est disposée une couche (1) du type sérigraphié thermiquement isolante, en ce que la couche de matériau conducteur supérieure (4) est en même temps une couche thermiquement absorbante, et en ce que le matériau céramique (3) piézoélectrique présente en même temps des propriétés pyroélectriques.
Application : détecteurs de phénomènes thermiques

FIG. 2

EP 0 435 397 A1

## "ELEMENT DETECTEUR PYROELECTRIQUE ET DISPOSITIFS POUR LA DETECTION DE PHENOMENES THERMIQUES"

L'invention concerne un élément détecteur pyroélectrique, comprenant sur un substrat une couche du type sérigraphié d'un matériau céramique piézoélectrique disposée entre deux couches du type sérigraphié de matériaux conducteurs constituant des électrodes.

L'invention concerne également des dispositifs pour la détection de phénomènes thermiques, comprenant au moins un élément détecteur pyroélectrique.

L'invention trouve son application dans la réalisation de détecteurs de présence utilisant l'effet pyroélectrique, et dans la réalisation de détecteurs de présence utilisant à la fois l'effet pyro- et piézoélectrique pour minimiser les fausses alarmes. L'invention trouve plus particulièrement son application dans la réalisation de détecteurs de phénomènes thermiques capables de produire une imagerie dans le domaine de l'infrarouge. L'invention trouve encore son application dans la détection de phénomènes thermiques variés.

Il est déjà connu du brevet GB 2 161 647, de réaliser un élément détecteur utilisant seulement l'effet piézoélectrique. Cet élément comprend une couche d'un matériau de titanozirconate de plomb, éventuellement dopé, associé à un liant vitreux.

Cette couche est réalisée à partir d'une poudre de céramique potentiellement piézoélectrique, dont les grains sont de quelques dizaines de $\mu$m, appropriés à la technique de sérigraphie, associée à un liant vitreux en poudre. L'ensemble est porté au point de ramollissement du liant vitreux qui forme alors une couche de liaison entre les grains de céramique piézoélectrique. Le liant est dit vitreux du fait qu'il n'est pas cristallin. On peut utiliser comme liant vitreux : le borosilicate de plomb, ou un composé de $SiO_2$, $Na_2CO_4$, CaO associés à d'autres oxydes métalliques. Le rapport entre la céramique piézoélectrique et le liant vitreux, en poids doit être compris entre 1/1 et 5/1. La poudre céramique incorporée au liant vitreux dans un liquide rhéologique est appliquée sous forme de pâte (ou encre) sur un substrat, puis l'ensemble est séché à une température convenable pour éliminer le liquide rhéologique. Un liquide rhéologique convenable peut être formé d'éthyl-cellulose (5 %) dissout dans un terpinéol (95 %) en poids).

La couche piézoélectrique est appliquée de préférence sur un substrat par une méthode de sérigraphie, éventuellement avec masquage de certaines parties du substrat.

Pour obtenir que la couche jusqu'ici seulement potentiellement piézoélectrique acquiert des propriétés piézoélectriques définitives, le dispositif est porté à une température légèrement supérieure à la température de Curie, tandis qu'un champ électrique continu intense lui est appliqué. Après un laps de temps suffisant pour permettre l'alignement préférentiel des dipôles des microcristaux piézoélectriques, le dispositif est refroidi en maintenant le champ constant.

Selon le document GB 2 161 647, le substrat sur lequel la couche piézoélectrique est réalisée, peut être un métal tel que l'INVAR, un alliage fer-nickel, un borosilicate, ou encore une céramique, par exemple l'alumine. Si l'alumine ou un borosilicate est utilisé, le liant de la poudre piézoélectrique sera un verre fritté.

Pour réaliser le dispositif piézoélectrique lui-même, la couche piézoélectrique est de préférence disposée entre deux électrodes. De préférence, ces électrodes sont réalisées par sérigraphie au moyen de pâtes à l'or ou l'argent. Si des pâtes moins onéreuses sont choisies pour réaliser les électrodes, comme les pâtes au cuivre ou au nickel, elles doivent alors impérativement être cuites dans une atmosphère inerte afin d'éviter l'oxydation de la couche qui en résulte.

Un élément pyroélectrique pour détecteur de passage ou d'intrus est par ailleurs connu du brevet FR 2 527 814. Ce document décrit des éléments actifs incorporés dans un détecteur muni d'une alarme. Ces éléments présentent deux parties, l'une prévue pour la détection pyroélectrique et l'autre pour la détection piézoélectrique, dans le but d'utiliser la coïncidence des signaux provenant des deux effets, pour diminuer la probabilité de déclenchement des fausses alarmes.

Le document cité enseigne que plusieurs types de matériaux peuvent être utilisés pour réaliser des éléments actifs à la fois pyro et piézo-électriques :
- d'une part des titano-zirconates de plomb,
- d'autre part des polyfluorures de vinylène, ses copolymères tels que le polytétrafluorure éthylène, l'hexafluoropropène, et le polytrifluoroéthylène ainsi que par exemple le polyméthylmétacrylate.

Ces matériaux acquièrent les propriétés piézo et pyroélectrique après des traitements spécifiques comprenant au moins une phase de polarisation sous champ électrique intense.

Pour les applications grand public, les matériaux de faibles coûts sont préférés, et à cet effet le document cité enseigne que les polymères présentent plusieurs avantages :
- ces matériaux sont d'un faible coût,

- ils peuvent être réalisés en grande surface avant d'être découpés aux dimensions requises et selon des formes appropriées.

Au contraire, les céramiques à base de titanozirconate de plomb, qui se présentent sous forme de plaquettes, sont coûteuses du fait qu'elles sont massives et qu'elles doivent être polarisées pièce par pièce. Les plus coûteuses sont celles qui sont monocristallines.

Cependant, si les polymères semblent, par leur coût, mieux appropriés aux applications grand public, ils présentent par ailleurs des inconvénients nombreux et importants :

- il deviennent dangereux lorsqu'ils sont stockés en grand nombre car ils se décomposent aux températures élevées, atteintes par exemple en cas d'incendie, pour donner des gaz toxiques, notamment des gaz fluorés ;
- ils vieillissent et se dépolarisent après un certain laps de temps, alors que les céramiques restent polarisées plus de 100 ans ;
- ils sont beaucoup moins sensibles que les céramiques de titanozirconate de plomb et leur dérivée, c'est-à-dire que le phénomène thermique à détecter doit émettre une puissance beaucoup plus grande. Les polymères peuvent donc être inefficaces dans certains cas.

D'autre part, bien que le brevet FR 2 527 814 enseigne que le titanozirconate de plomb possède, outre les propriétés piézoélectriques, des propriétés pyroélectriques, l'élément piézoélectrique du brevet GB 2 161 647 ne peut pas constituer un élément pyroélectrique. En effet, du fait que la couche de titanozirconate de plomb réalisée par sérigraphie est très peu épaisse et du fait qu'elle est disposée entre deux couches métalliques, donc très conductrices, sur un substrat qui est, quant à lui, relativement épais, les quantités de rayonnement infrarouge détectées sont immédiatement dissipées dans le substrat via la couche conductrice inférieure, et dans l'atmosphère via la couche conductrice supérieure.

Par conséquent, en combinant l'enseignement des deux documents cités, on ne peut pas obtenir un élément pyroélectrique, même en considérant que la couche piézoélectrique de l'élément du brevet GB 2 161 647 est aussi pyroélectrique.

Un objet de la présente invention est de proposer un élément détecteur pyroélectrique, facile à réaliser sur le plan industriel, d'un coût faible pour les applications grand public, qui ne dégage pas d'éléments nocifs en cas de destruction par la chaleur ou autre, dont la partie active peut présenter tout dessin approprié à un meilleur rendement, ou à une plus grande facilité d'exécution, ou à une plus grande longévité, ou à de plus nombreuses applications quand il est inséré dans un détecteur de phénomènes thermiques.

Un objet de la présente invention est de proposer un élément détecteur pyroélectrique qui possède en outre des propriétés pyroélectriques, pour la réalisation de détecteurs de présence par exemple.

Selon l'invention ces buts sont atteints au moyen d'un élément détecteur tel que décrit dans le préambule de la revendication 1, en outre caractérisé en ce qu'entre la première couche de matériau conducteur et le substrat, est disposée une couche du type sérigraphié thermiquement isolante, en ce que la couche de matériau conducteur supérieure est en même temps une couche thermiquement absorbante, et en ce que le matériau céramique piézoélectrique présente en même temps des propriétés pyroélectriques.

Un tel élément détecteur est facile à réaliser, peu coûteux (pratiquement 10 fois moins coûteux qu'un élément détecteur à céramique pyroélectrique massive), très sensible, en particulier plus sensible que les éléments à polymères pyroélectriques, et d'une plus grande longévité. De plus, il permet des applications inconnues jusqu'ici.

Un autre objet de l'invention est de proposer un dispositif pour la détection de phénomènes thermiques incluant un tel élément détecteur pyroélectrique.

Un objet de l'invention est aussi de proposer un dispositif détecteur de présence incluant de tels éléments détecteurs pyroélectriques dont on utilise d'une part la fonction pyroélectrique et d'autre part la fonction piézoélectrique pour minimiser les fausses alarmes.

Un objet de l'invention est aussi de proposer un dispositif pour la détection de phénomènes thermiques, en forme de barrette, incluant une pluralité de tels éléments.

Un objet de l'invention est aussi de proposer un dispositif pour la détection de phénomènes thermiques, en forme de matrice, incluant une pluralité de tels éléments.

Un objet de l'invention est aussi de proposer un dispositif pour la détection de phénomènes thermiques en outre muni d'une optique.

Un objet de l'invention est aussi de proposer un tel dispositif pour la détection de phénomènes thermiques, ayant la forme d'une matrice et muni d'une optique, pour effectuer la reconnaissance de forme, ou procurer une imagerie infrarouge.

Ces derniers dispositifs trouvent leur application dans la détection de passage ou de présence, avec reconnaissance de silhouettes. Ils sont particulièrement avantageux dans le cas où il est important de distinguer le passage d'un être humain -cas où le déclenchement d'une alarme est requis, du passage d'un animal par exemple- cas où le déclenchement de l'alarme n'est pas requis.

Ces derniers dispositifs trouvent encore leur application dans la réalisation d'images infrarouges, par exemple par points, dans les cas où une définition faible ou moyenne est acceptable.

L'invention sera mieux comprise au moyen de la description suivante illustrée par les figures annexées dont :

- la figure 1 qui représente schématiquement vu du dessus et à titre exemplatif, une portion d'un dispositif détecteur de phénomènes thermiques en forme de barrette ;
- la figure 2 qui représente le même dispositif en coupe selon l'axe I-I ;
- la figure 3 qui représente schématiquement vu du dessus, et à titre exemplatif, un dispositif détecteur de phénomènes thermiques, en forme de matrice ;
- la figure 4 qui représente des courbes de sensibilité au rayonnement infrarouge, d'un élément détecteur pyroélectrique, la fréquence F du rayonnement étant portée en abscisse et la tension V du signal détecté étant portée en ordonnée.

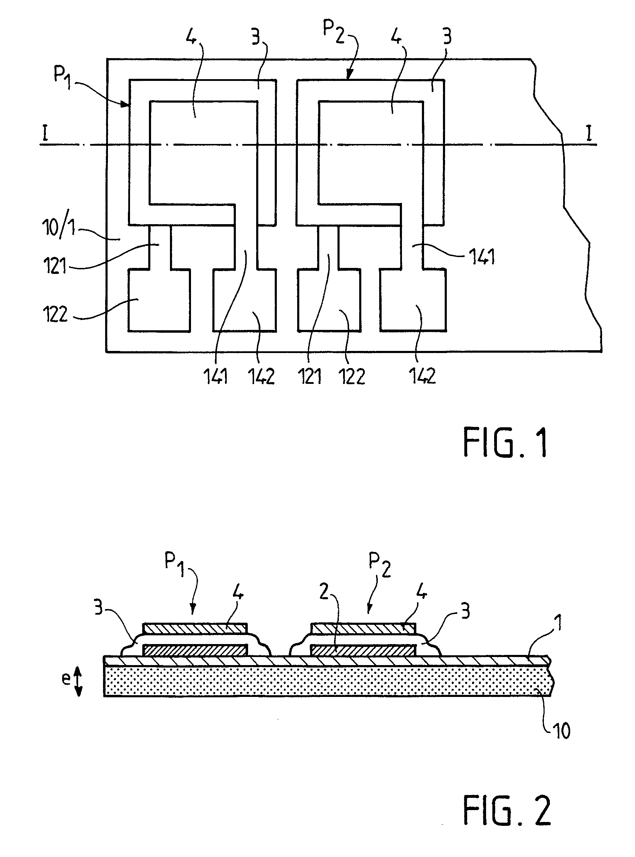

Tel que représenté en coupe sur la figure 2, un élément détecteur pyroélectrique P ($P_1$, $P_2$ ou $P_{ij}$) selon l'invention, comprend d'abord un support plan, ou substrat 10. Ce substrat peut être avantageusement en céramique et de préférence en alumine ($Al_2O_3$). Un substrat en alumine présente en effet les avantages de pouvoir être réalisé en toutes tailles désirables, et en différentes épaisseurs. Il est relativement bon marché, et connu pour ses qualités de résistances mécaniques aux chocs et à la chaleur. Ce substrat présente surtout l'avantage d'être particulièrement bien adapté à la réalisation de dispositifs ou de circuits électroniques par une méthode de sérigraphie, méthode peu onéreuse, facile à mettre en oeuvre, et qui permet la réalisation de couches de toutes formes. On choisira donc de réaliser un élément détecteur pyroélectrique, et des dispositifs détecteurs de phénomènes thermiques par une technologie mettant en oeuvre la sérigraphie.

On rappelle que l'impression par sérigraphie a pour but de transférer sur un substrat rigide, au travers d'un écran formant masque et délimitant un motif, un matériau pâteux ou encre qui, à l'issue d'un traitement thermique ou cuisson, présente par exemple des propriétés spécifiques de conducteur, d'isolant, piézo- ou pyroélectrique et devient en outre solidaire du substrat.

Pour remplir avant cuisson la fonction d'impression et après cuisson une fonction électrique et mécanique, une encre comprend essentiellement trois composants : un véhicule organique liquide qui remplit la fonction impression et qui est dit rhéologique, et qui doit être éliminé lors de la cuisson, un matériau actif qui remplit la fonction spécifique voulue, et un matériau destiné à rendre le précédent solidaire du substrat après cuisson et qui est un liant.

Chacune des couches formant un circuit doit être à la fois compatible avec les autres couches du circuit et avec le substrat choisi tant en ce qui concerne les coefficients de dilatation que les températures de cuisson.

C'est pourquoi les formulations des encres doivent être spécialement adaptées à chaque cas précis d'utilisation.

Tel que représenté sur la figure 2 en coupe, l'élément P comprend un empilement, sur le substrat 10 des couches suivantes dans l'ordre :

a) une couche 1, qui permet d'une part l'adaptation au substrat des couches ultérieurement réalisées, et qui a d'autre part pour fonction particulièrement importante d'être thermiquement isolante.

b) une couche 2 conductrice électriquement, pour former la première électrode de l'élément pyroélectrique ;

c) une couche 3 dont l'élément actif est une céramique ayant des propriétés à la fois pyroélectrique et piézoélectrique (il existe en effet des céramiques qui ont des propriétés piézoélectriques mais qui sont dénuées de propriétés pyroélectriques). On verra plus loin que l'association de ces deux propriétés est importante pour la réalisation de détecteurs d'intrus comme connu du brevet FR 2 527 814.

d) une couche 4 qui a pour première fonction d'être conductrice afin de former la seconde électrode de l'élément pyroélectrique et qui a pour seconde fonction particulièrement importante d'être thermiquement absorbante, de manière à augmenter la sensibilité de l'élément pyroélectrique dans le domaine infrarouge.

La figure 1 est une coupe selon l'axe I-I de la figure 2. Cette dernière montre vu du dessus comment sont disposées les couches décrites précédemment.

On donne ci-après les mélanges de départ pour réaliser des compositions sérigraphiables appropriées à former les couches 1 à 4 nécessaires à la mise en oeuvre d'un élément P sur un substrat en céramique et de préférence en alumine $Al_2O_3$.

Pour réaliser une encre sérigraphiable, on réalise d'abord le liant vitreux à partir de différents oxydes. Ces oxydes sont fondus dans les proportions molaires qui seront indiquées plus loin pour chacune des compositions des couches 1, 2, 3 ou 4. Puis le verre obtenu par cette fusion est refroidi par une trempe, formant une fritte de verre, et cette dernière est broyée de manière à obtenir des grains de quelques micromètres à 10 $\mu$m environ.

La poudre de verre obtenue est alors mélangée à l'élément actif de la composition sérigraphiable, cet élément actif étant sous forme de poudre dont les grains sont du même ordre de grandeur que ceux de la poudre de verre. Le mélange est fait dans des proportions volumiques données plus loin, ou dans des proportions pondérales selon le cas.

L'encre sérigraphiable est ensuite obtenue par la dispersion du mélange formé de la poudre de verre et de la poudre de l'élément actif dans une solution rhéologique constituée par exemple de quelques pour cents, de préférence 4 %, d'étyl-cellulose dans du terpinéol. D'autres liquides rhéologiques connus de l'homme du métier peuvent être utilisés.

Pour réaliser l'encre sérigraphiable, les proportions du mélange dispersé dans le liquide rhéologique seront données plus loin.

A/ Mélange de départ pour la réalisation de la couche 1 thermiquement isolante et procédé d'application de cette couche

On réalise d'abord une poudre de verre $\alpha_1$ comme décrit précédemment à partir des oxydes :

$$\alpha_1 \text{ (verre)} \begin{cases} B_2O_3 & 20 \text{ \% en moles,} \\ S_iO_2 & 25 \text{ \% " " ,} \\ PbO & 45 \text{ \% " " ,} \\ Al_2O_3 & 10 \text{ \% " "} \end{cases}$$

On réalise ensuite une poudre $\alpha_2$ de l'élément actif thermiquement isolant :

$$\alpha_2 \text{ (isolant thermique)} \begin{vmatrix} ZrO_2 \end{vmatrix}$$

On effectue le mélange entre la poudre de verre $\alpha_1$ et l'élément actif $\alpha_2$ pour obtenir la composition $\alpha_3$ thermiquement isolante, dans les proportions :

$$\alpha_3 \begin{cases} \alpha_2 \text{ (isolant thermique)} & 80 \text{ à } 98 \text{ \%} \quad \text{préféré 95 \% en volume} \\ \alpha_1 \text{ (verre)} & 20 \text{ à } 2 \text{ \%} \quad \text{préféré 5 \% en volume.} \end{cases}$$

On obtient la pâte sérigraphiable par la dispersion du mélange $\alpha_3$ dans le liquide rhéologique dans les proportions :

$$\alpha_3 \text{ (composition thermiquement isolante)} \quad 70 \text{ \% en poids}$$
$$\text{Liquide rhéologique} \quad 30 \text{ \% en poids}$$

Une couche 1 de cette encre est déposée à travers un tamis ou écran sur la plus grande partie du substrat 10, puis elle est soumise à une cuisson à 850° C environ avec un palier d'environ 10 mn dans une atmosphère oxydante.

5

B/ Mélange de départ pour la réalisation de la première électrode 2 de l'élément pyroélectrique et procédé d'application de cette couche.

On réalise d'abord une poudre de verre $\beta_1$ à partir des oxydes :

|         |           |                |
|---------|-----------|----------------|
| $\beta_1$ | $B_2O_3$ | 21 % en moles |
| (verre) | $SiO_2$ | 24 % en moles |
|         | PbO | 45 % en moles |
|         | $Al_2O_3$ | 10 % en moles |

On réalise ensuite une poudre $\beta_2$ de l'élément actif, ici conducteur, et apte à supporter une cuisson en atmosphère oxydante de manière à être adaptée à la réalisation des autres couches de l'élément pyroélectrique P, qui comme on le verra doivent obligatoirement subir une oxydation.

|              |    |                    |
|--------------|----|--------------------|
| $\beta_2$ | Ag | 80 à 70 % en poids |
| (conducteur) | Pd | 20 à 30 % en poids. |

On effectue le mélange entre la poudre de verre $\beta_1$ et l'élément actif conducteur $\beta_2$ pour obtenir la composition $\beta_3$ conductrice, dans les proportions :

|         |                       |                      |
|---------|-----------------------|----------------------|
| $\beta_3$ | $\beta_2$(conducteur) | 90 à 99 % en poids |
|         | $\beta_1$(verre)      | 10 à 1 % en poids. |

On obtient l'encre sérigraphiable par la dispersion de la composition $\beta_3$ dans le liquide rhéologique dans les proportions :

|                                      |                |
|--------------------------------------|----------------|
| $\beta_3$(composition conductrice) | 80 % en poids |
| Liquide rhéologique                  | 20 % en poids. |

Une ou plusieurs couches de cette encre sont étendues à travers un tamis ou écran muni d'un masque pour réaliser le motif approprié à former la première électrode 2 de l'élément pyroélectrique P ainsi qu'une connexion 121 reliant cette électrode à un plot de contact 122. Le plot de contact 122 peut également être réalisé au moyen de la même encre dans la même étape ou par tout autre moyen connu de l'homme du métier des circuits hybrides (voir la figure 1).

C/ Mélange de départ pour la réalisation de la couche à la fois piézoélectrique et pyroélectrique 3 et procédé d'application de cette couche

On réalise d'abord une poudre de verre $\gamma_1$ à partir des oxydes :

|         |                                                     |
|---------|-----------------------------------------------------|
| $\gamma_1$ | $B_2O_3$ 20 à 50 % en moles, préféré 25 % moles |
| (verre) | $SiO_2$ 10 à 40 % en moles, préféré 35 % moles |
|         | PbO 14 à 35 % en moles, préféré 30 % moles |
|         | $Al_2O_3$ 0 à 10 % en moles, préféré 5 % moles |
|         | CaO complément < 10 %, préféré 5 % moles |

EP 0 435 397 A1

On réalise ensuite une poudre $\gamma_2$ de l'élément actif, ici une céramique potentiellenent pyroélectrique et potentiellement piézoélectrique.

| $\gamma_2$ (pyroélectrique) | $Pb\ Ti_x\ Zr_{1-x}\ O_3$ Composé dans lequel $x = 0,25$ à $0,5$, préféré $1/3$ L'élément Pb peut être substitué par La ou Bi Les éléments Ti et Zr peuvent être remplacés par Fe, Nb, Mn. |
|---|---|

Si la composition pyro-piézoélectrique $\gamma_2$ a pour formulation $PbTi_{1/3}\ Zr_{2/3}\ O_3$, le coefficient pyroélectrique est équivalent à 30 $nC.cm^{-2}.K^{-1}$.

La composition pyroélectrique $\gamma_2$ est mélangée au verre $\gamma_1$ dans les proportions suivantes, pour obtenir le mélange de départ $\gamma_3$ :

| $\gamma_3$ (pyroélectrique) | $\gamma_2$ (composition pyroélectrique) 95 à 85 % en volume) préféré 88 % en volume $\gamma_1$ (verre) complément en volume. |
|---|---|

Le mélange de départ $\gamma_3$ est dispersé dans le liquide rhéologique dans les proportions :

| | |
|---|---|
| $\gamma_3$ (mélange pyroélectrique) | 60 % en volume |
| Liquide rhéologique | 40 % en volume |

Deux à cinq couches 3 de l'encre potentiellement piézo-pyroélectrique ainsi préparée, sont déposées à travers un tamis ou écran muni d'un masque sur la portion de surface de la première électrode 2. Ces couches sont soumises à une cuisson à environ 850° C, avec un palier d'environ 10 mn, une étape de cuisson intervenant entre chaque dépôt.

Le motif selon lequel ces couches pyroélectriques 3 sont déposées est prévu pour dépasser les lisières de la surface de la première électrode 2 afin d'isoler cette électrode 2, de l'électrode supérieure 4 réalisée par la suite (voir la figure 1).

D/ Mélange de départ cour la réalisation de la seconde électrode 4 de l'élément pyroélectrique, et procédé d'application de cette couche à la fois conductrice et thermiquement absorbante

On réalise d'abord une poudre de verre $\delta_1$

| $\delta_1$ (verre) | $B_2O_3$ | 20 % en moles |
|---|---|---|
| | $SiO_2$ | 25 % en moles |
| | PbO | 45 % en moles |
| | $Al_2O_3$ | 10 % en moles |

On réalise ensuite une poudre $\delta_2$ à propriétés à la fois conductrice électriquement, et thermiquement absorbante, dont on donne directement les proportions en mélange $\delta_3$ avec le verre $\delta_1$ :

7

$$\delta_3 \begin{array}{|l|l} \delta_2 & \text{Ag} \quad\quad 20 \text{ à } 50 \text{ \% en volume, préféré } 36 \text{ \%} \\ \text{absorbant} & \text{Cu}_2\text{O} \quad 80 \text{ à } 30 \text{ \% en volume, préféré } 50 \text{ \%} \\ \text{conducteur} & \text{Pd complément} < 25 \text{ \% en volume, préféré } 9 \text{ \%} \end{array}$$

$$\begin{array}{|l|l} \delta_1 & \\ \text{(verre)} & 2 \text{ à } 20 \text{ \% en volume, préféré } 5 \text{ \%.} \end{array}$$

Le mélange de départ pour une composition à la fois conductrice et thermiquement absorbante est dispersé dans le liquide rhéologique, dans les proportions :

$$\delta_3 \text{ (conducteur absorbant) } 80 \text{ \% en volume}$$
$$\text{Liquide rhéologique} \quad\quad 20 \text{ \% en volume.}$$

Une ou deux couches de l'encre ainsi formée sont déposée(s) à travers un tamis ou écran muni d'un masque pour réaliser un motif approprié à former la seconde électrode 4 de l'élément pyroélectrique P. On réalise aussi de préférence dans la même étape une connexion 141 reliant cette électrode 4 à un plot de contact 142. La connexion 141 et le plot 142 peuvent être réalisés soit en employant la composition $\delta_2$ conductrice et thermiquement absorbante, soit en employant la composition $\beta_2$ uniquement conductrice, soit en employant éventuellement une autre encre conductrice connue de l'homme du métier à condition que cette encre puisse être soumise à une cuisson à environ 850°C sous atmosphère oxydante (voir la figure 1).

A l'issue de cette série d'étapes, le dispositif ou élément selon l'invention est seulement potentiellement piézo ou potentiellement pyroélectrique. Pour obtenir une polarisation, qui dans le cas de la céramique de titanozirconate de plomb est extrêmement stable sur des périodes de temps dépassant largement une vie humaine, on soumet l'élément ou dispositif à une tension, appliquée simplement entre ses électrodes par les plots 122 et 142, de l'ordre de 2 kV par mm d'épaisseur de couche piézo-pyroélectrique, tout en portant l'élément ou dispositif à une température comprise entre 120 et 180°C, c'est-à-dire supérieure au point de Curie pendant une durée de l'ordre de 5 à 10 mn, puis en le laissant refroidir lentement jusqu'à la température ambiante tout en le maintenant sous tension. L'orientation des dipôles des microcristaux se produit essentiellement durant le refroidissement au moment où le matériau se trouve au voisinage du point de Curie, et conserve cette orientation si le champ électrique est maintenu durant le refroidissement.

On remarquera que la couche 3, ou couche pyroélectrique est évidemment essentielle à la réalisation d'un élément pyroélectrique, mais qu'une couche équivalente était déjà connue pour ses propriétés piézoélectriques. On remarquera également que le fait de disposer une telle couche entre des électrodes conductrices était aussi connu.

Mais il faut mettre en évidence que le fonctionnement piézoélectrique et le fonctionnement pyroélectrique présentent des différences fondamentales.

Pour un fonctionnement piézoélectrique la simple application d'une tension mécanique ou l'émission d'une onde acoustique dans certaines conditions, résulte immédiatement en un signal électrique.

Pour un fonctionnement pyroélectrique, il en serait de même, à la seule condition que l'onde infrarouge ne soit pas dissipée dans les parties annexes du détecteur.

En effet, le fait de réaliser un élément pyroélectrique au moyen d'une couche (éventuellement constituée de plusieurs couches minces superposées) possède à la fois des avantages et des désavantages.

Les avantages sont que :
- la puissance nécessaire pour obtenir une détecteur est beaucoup plus faible que si l'élément en céramique pyroélectrique est massif, ou si l'élément pyroélectrique est en polymère. Donc l'élément est beaucoup plus sensible,
- la réalisation est facile, du fait que la sérigraphie est une des techniques les moins coûteuses et les plus aisées à mettre en oeuvre,
- la surface détectrice de l'élément pourra présenter les formes les plus variées, la sérigraphie étant une technique des plus souples. On pourra réaliser des matrices de points détecteurs I.R et faire de l'imagerie infrarouge avec une définition qui peut être relativement bonne si le nombre de points réalisés est grand et si on adjoint à la matrice une optique de focalisation qui est appropriée.

En revanche, les inconvénients sont que :

- du fait de la faible épaisseur du matériau pyroélectrique, justement la puissance qui est facilement emmagasinée, est tout aussi facilement dissipée, et notamment dans le substrat, dans l'électrode inférieure qui joue alors le rôle de radiateur, ainsi que dans l'électrode supérieure.

Selon l'invention cependant ce problème est résolu au moyen de la couche 1 thermiquement isolante qui empêche la dissipation de l'énergie dans le substrat, et au moyen de la couche 4 thermiquement absorbante qui améliore la sensibilité de la couche 3 sous-jacente pyroélectrique et qui prévient les pertes par radiation dans l'air à la surface de l'élément p.

On remarquera encore que, s'il est impossible de réaliser un élément pyroélectrique à partir de l'élément piézoélectrique du brevet GB pris tel quel, en revanche il est tout à fait possible de réaliser un élément piézoélectrique à partir de l'élément pyroélectrique P selon l'invention.

Ainsi on pourra appliquer l'élément P selon l'invention à la réalisation d'un détecteur d'intrus connu du brevet FR où il est nécessaire de disposer de deux éléments l'un pyro, l'autre piézoélectrique montés en inverse pour éliminer les fausses alarmes. On réalisera deux éléments p selon l'invention que l'on utilisera dans leurs fonctions différentes, car il revient toujours industriellement moins cher de réaliser des éléments identiques, en grande série.

On pourra aussi appliquer l'élément P seul à la détection d'un phénomène thermique quelconque, détection de passage, de présence, de chauffage d'un appareil ou d'un bâtiment, d'incendie, etc...

Cependant une application originale de l'invention réside dans la réalisation simple et peu coûteuse d'une imagerie infrarouge. Des détecteurs pyroélectriques, incluant des éléments pyroélectriques décrits précédemment, vont être décrits à titre d'exemple ci-après.

I/ Exemple de réalisation de détecteur pyroélectrique en forme de barrette

Cet exemple est illustré par la figure 1 vu du dessus et par la figure 2 en coupe.

Tel que représenté sur la figure 1, schématiquement vu du dessus, un substrat 10 comporte un nombre N d'éléments pyroélectriques P disposés en ligne pour former une barrette, soit $P_1$, $P_2$,...$P_N$. Sur la figure 1 on a représenté seulement les deux premiers éléments $P_1$, $P_2$ pour simplifier la figure. Comme on l'a dit ces éléments sont conformes aux éléments décrits précédemment.

Le substrat muni des éléments peut être associé à une optique, comme connu par exemple du brevet FR cité, ou autrement connu de l'homme du métier.

Le dispositif en forme de barrette peut être monté dans un boîtier scellé hermétiquement pour le protéger des influences extérieures, et muni d'une fenêtre, par exemple en silicium, matériau transparent au rayonnement infrarouge. L'optique elle-même peut être en silicium, ce qui est cependant onéreux, ou bien en polyéthylène qui transmet le rayonnement infrarouge dans la gamme 8 à 14 $\mu$m. L'optique peut aussi consister en une lentille qui a pour double fonction de concentrer le rayonnement à détecter sur la surface du dispositif, et de former en même temps la fenêtre du boîtier.

Le dispositif pyroélectrique en forme de barrette peut être relié à des dispositifs électroniques de traitement du signal, connus de l'homme du métier électronicien, qui ne font pas à proprement parler partie de l'invention et ne seront donc pas décrits ici. Les plots 121 et 141 (voir la figure 1) servent à connecter les divers éléments pyroélectriques $P_1$...$P_N$ à ces dispositifs électroniques.

II/ Exemple de réalisation de détecteur pyroélectrique en forme de matrice

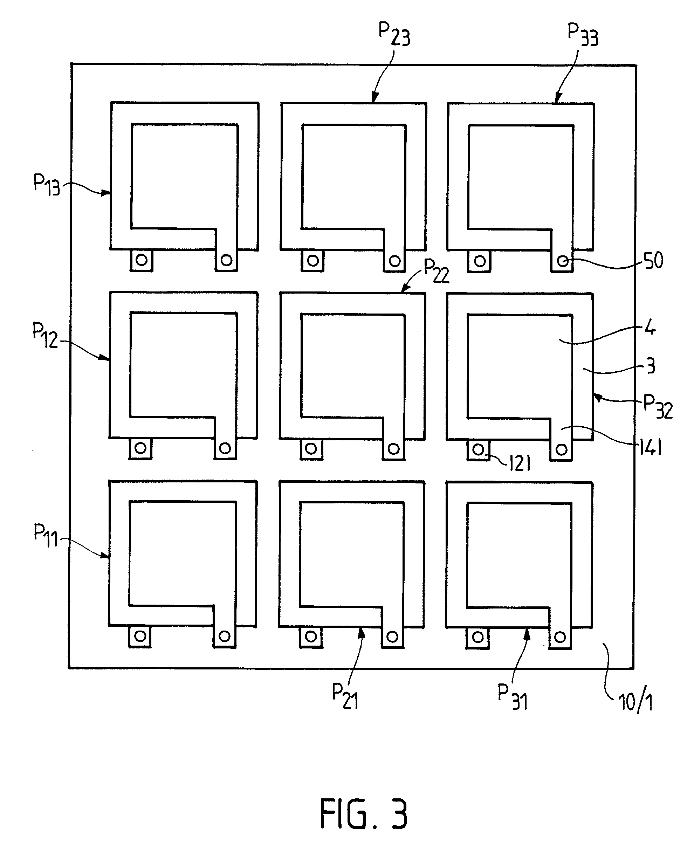

Cet exemple est illustré par la figure 3 vu du dessus schématiquement.

Tel que représenté sur cette figure 3, le substrat 10 comporte ici N x M éléments pyroélectriques P formant un motif bidimensionnel, avec des lignes et des colonnes, défini comme une matrice.

Chaque élément de la matrice est repéré par une référence $P_{ij}$. La matrice représentée sur la figure 3 à titre d'exemple comporte 3 lignes et 3 colonnes.

Plus les éléments seront nombreux, et donc les lignes et les colonnes, et meilleure sera la résolution du dispositif.

On peut réaliser la dimension des éléments entre 0,8 mn et 2 mm par exemple. Ils peuvent être carrés ou rectangulaires, ou même circulaires. D'une manière générale ces considérations peuvent être appliquées à tout élément déjà décrit et à tout dispositif détecteur utilisant ces éléments décrits plus haut.

Dans le cas où les éléments sont suffisamment nombreux, on pourra obtenir une définition suffisante pour obtenir par traitement des signaux, une image infrarouge, ou au moins une reconnaissance de silhouette.

Pour obtenir cet effet, on associera comme décrit dans l'exemple I précédent un boîtier et une optique au dispositif détecteur en forme de matrice. D'une manière générale boîtier et optique peuvent être appliqués à tout élément déjà décrit et à tout dispositif détecteur incluant des éléments pyroélectriques selon l'invention.

Dans la réalisation de la matrice, la réalisation des fils de connexions reliant les électrodes aux plots de sortie peut se poser si l'on désire réaliser les éléments d'une manière très dense. On dispose alors de très peu de place entre les éléments. Une solution à ce problème consiste à réaliser des lignes d'interconnexion courtes 121 et 141 en contact avec des trous métallisés 50 traversant le substrat. Les plots de sortie sont alors réalisés sur la face inférieure du substrat et reliés par un circuit approprié également réalisé sur cette face inférieure, à l'autre extrémité des trous métallisés 50, établissant ainsi les connexions avec les électrodes des éléments $P_{ij}$.

Les trous métallisés et les lignes du circuit peuvent être réalisés au moyen des matériaux sérigraphiables conducteurs déjà décrits.

III/ Résultats obtenus au moyen d'un élément pyroélectrique

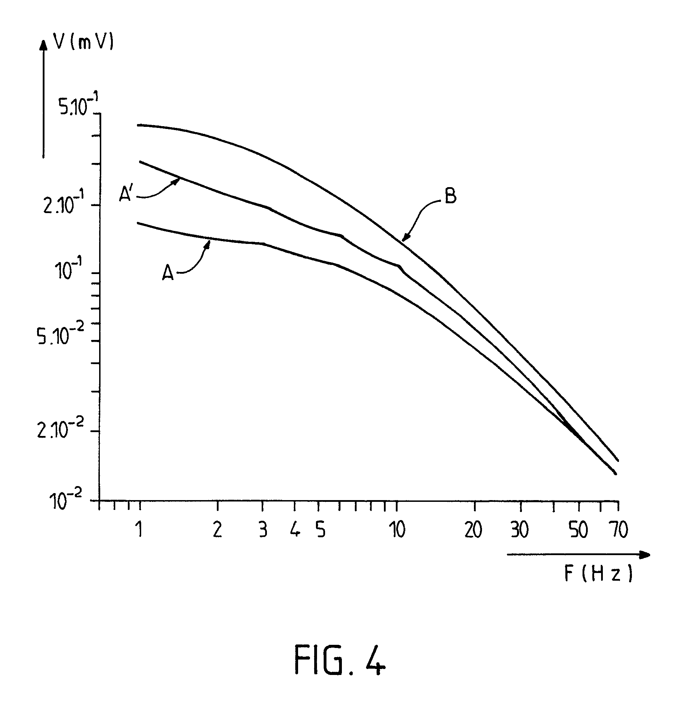

Les courbes de la figure 4 montrent la réponse en tension V en fonction de la fréquence F d'un élément pyroélectrique selon l'invention. Ces courbes ont été tracées avec et sans isolants 1 et pour différentes épaisseurs e du substrat. D'une manière générale l'isolant 1 fait en sorte que l'épaisseur du substrat est indifférente.

En effet, la courbe A montre la réponse en tension V de l'élément pyroélectrique P lorsque le substrat 10 a une épaisseur (voir figure 2) :
e : 1 mm et est dépourvu de couche isolante thermiquement 1.

La courbe A' montre la réponse en tension V de l'élément pyroélectrique P lorsque le substrat 10 a une épaisseur
e = 0,25 mm et est dépourvu de couche thermiquement isolante 1. On constate que la réponse est améliorée, mais en revanche l'épaisseur très faible du substrat rend le dispositif fragile, et par conséquent difficile à réaliser industriellement avec le meilleur rendement possible.

La courbe B montre la réponse en tension V dans le cas où le substrat a une épaisseur quelconque comprise entre 0,25 mm et 1 mm, et est muni d'une couche 1 thermiquement isolante. On constate que l'influence de l'épaisseur du substrat est devenue pratiquement indifférente au fonctionnement du dispositif.

**Revendications**

1. Elément détecteur pyroélectrique, comprenant sur un substrat une couche du type sérigraphié d'un matériau céramique piézoélectrique disposée entre deux couches du type sérigraphié de matériaux conducteurs constituant des électrodes, caractérisé en ce qu'entre la première couche de matériau conducteur et le substrat, est disposée une couche du type sérigraphié thermiquement isolante, en ce que la couche de matériau conducteur supérieure est en même temps une couche thermiquement absorbante, et en ce que le matériau céramique piézoélectrique présente en même temps des propriétés pyroélectriques.

2. Elément selon la revendication 1, caractérisé en ce que la composition pour réaliser la couche thermiquement isolante comprend 80 à 98 % en volume d'oxyde de zirconium ($ZrO_2$) comme matériau actif, et la proportion complémentaire d'un verre.

3. Elément selon la revendication 2, caractérisé en ce que la composition pour réaliser la couche thermiquement isolante comprend 95 % en volume d'oxyde de zirconium comme élément actif et 5 % en volume d'un verre.

4. Elément selon la revendication 3, caractérisé en ce que le verre entrant dans la composition thermiquement isolante est formé en proportions molaires de 20 % de $B_2O_3$, de 25 % de $SiO_2$, de 45 % de PbO et de 10 % d'$Al_2O_3$.

5. Elément selon l'une des revendications 1 à 4, caractérisé en ce que la composition pour réaliser la couche thermiquement absorbante, comprend en volume, 2 à 20 % d'un verre, et comme éléments actifs 20 à 50 % d'Ag, 80 à 30 % de $Cu_2O$, un complément éventuellement de Pd dans la mesure où il

EP 0 435 397 A1

est inférieur à 25 %, la somme des proportions volumiques précédentes étant choisies pour atteindre la valeur 100 %.

6. Elément selon la revendication 5, caractérisé en ce que la composition pour réaliser la couche thermiquement absorbante comprend en volume, 5 % d'un verre, 36 % d'Ag, 50 % de $Cu_2O$, et 9 % de Pd.

7. Elément selon la revendication 7, caractérisé en ce que le verre entrant dans la composition thermiquement absorbante comprend en proportions molaires 20 % de $B_2O_3$, 25 % de $SiO_2$, 45 % de PbO, et 10 % de $Al_2O_3$.

8. Elément selon l'une des revendications 1 à 7, caractérisé en ce que la composition pour réaliser la première électrode ou électrode inférieure en contact avec la couche thermiquement isolante, comprend en poids 90 à 99˚ d'un composé actif conducteur, et 10 à 1 % d'un verre.

9. Elément selon la revendication 8, caractérisé en ce que le composé actif conducteur est formé, en poids, de 80 à 70 % d'Ag, et de 20 à 30 % de Pd.

10. Elément selon l'une des revendications 1 à 9, caractérisé en ce que la composition pour réaliser la couche céramique présentant à la fois des propriétés pyro- et piézoélectriques, comprend 95 à 85 % en volume d'un titanozirconate de Plomb de formule générale Pb $Ti_x$ $Zr_{1-x}O_3$) dans lequel x est de l'ordre de 0,25 à 0,5, et 5 à 15 % en volume d'un verre.

11. Elément selon la revendication 10, caractérisé en ce que dans la formule de la céramique pyro- et piézoélectrique Pb est remplacé par un élément choisi parmi La ou Bi, et Ti ou Zr sont remplacés par un élément choisi parmi Fe, Nb, Mn.

12. Elément selon l'une des revendications 10 ou 11, caractérisé en ce que le verre est formé en moles, de 20 à 50 % de $B_2O_3$, de 10 à 40 % de $SiO_2$, de 14 à 35 % de PbO, de O à 10 % d'$Al_2O_3$, et éventuellement d'un complément de CaO dans la mesure où il est inférieur à 10 %, les proportions molaires précédentes étant choisies pour obtenir la somme de 100 %.

13. Elément selon la revendication 12, caractérisé en ce que le verre est formé, en moles, de 25 % de $B_2O_3$, de 35 % de $SiO_2$, de 30 % de PbO, de 5 % d'$Al_2O_3$, de 5 % de CaO.

14. Procédé de réalisation d'un élément selon l'une des revendications 1 à 13, caractérisé en ce que chaque composition respectivement thermiquement isolante, conductrice, pyro-piézoélectrique, thermiquement absorbante, est dispersée individuellement, sous forme de poudre dont les grains sont inférieurs ou de l'ordre de 10 $\mu$m, dans un liquide rhéologique, par exemple quelques pour cents d'éthyl-cellulose dans du terpinéol, dans les proportions de 80 à 98˚ en volume pour la composition thermiquement isolante, 80 % en poids pour la composition conductrice, 60 % en volume pour la composition pyro-piézoélectrique, 80 % en volume pour la composition thermiquement absorbante, en ce que les couches sont étendues les unes après les autres sur le substrat, à travers un écran éventuellement muni d'un masque, en ce qu'une cuisson à une température de l'ordre de 850˚ C avec un palier de l'ordre de 10 mn est pratiquée entre chaque dépôt de couche, et en ce qu'une polarisation de la couche pyro-piézoélectrique est pratiquée en élevant la température du dispositif au-dessus du point de Curie sous un champ électrique élevé qui est maintenu pendant le refroidissement du dispositif.

15. Détecteur piézoélectrique, caractérisé ence qu'il comprend au moins un élément selon l'une des revendications 1 à 13.

16. Détecteur de phénomènes thermiques, caractérisé en ce qu'il comprend au moins un élément selon l'une des revendications 1 à 13.

17. Détecteur de phénomènes thermiques comprenant une pluralité d'éléments selon l'une des revendications 1 à 13, ces éléments étant disposés en ligne pour former une barrette, et les électrodes de ces éléments étant reliées par des lignes d'interconnexions à des plots pour connecter les éléments à des moyens de traitement des informations provenant de ces éléments.

18. Détecteur de phénomènes thermiques comprenant une pluralité d'éléments selon l'une des revendications 1 à 13, ces éléments étant disposés d'une manière bidimensionnelle pour former une matrice et les électrodes des éléments étant reliées par des lignes d'interconnexions à des plots pour connecter les éléments à des moyens de traitement des informations provenant de ces éléments.

19. Détecteur selon l'une des revendications 15 à 18, caractérisé en ce que le substrat est muni de trous métallisés d'un type sérigraphié pour raccorder les lignes de connexions des éléments réalisés sur une face du substrat, dite face supérieure, à un circuit de lignes de connexions d'un type sérigraphié réalisé sur la face opposée du substrat dite face inférieure, ce circuit étant destiné à relier lesdites lignes d'interconnexions à des plots disposés sur la face inférieure du substrat pour connecter les éléments à des moyens de traitement des informations provenant des éléments.

20. Détecteur selon l'une des revendications 15 à 19, caractérisé en ce qu'il est monté dans un boîtier.

21. Détecteur selon l'une des revendications 16 à 20, caractérisé en ce qu'il est muni d'une optique pour concentrer le rayonnement sur la surface du détecteur.

FIG. 1

FIG. 2

FIG. 3

FIG. 4

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| D,Y | GB-A-2 161 647   (GENERAL ELECTRIC)<br>* Abrégé; page 1, lignes 89-116; page 1, ligne 121 - page 2, ligne 6; page 2, lignes 37-47,119-127; page 3, lignes 19-34; page 4, lignes 82-121 *<br>— — — | 1,2,10,11, 16,20 | G 01 J<br>5/34<br>H 01 L 37/02 |
| D,A |  | 14,15 |  |
| Y | EP-A-0 087 514   (PREH)<br>* Page 4, lignes 19-31; figure 3 *<br>— — — | 1,2,10,11, 16,20 |  |
| A | US-A-4 367 408   (IMAI)<br>* Abrégé; colonne 4, ligne 26 - colonne 5, ligne 4; colonne 5, lignes 18-22; figure 4 *<br>— — — | 1,2,10,11, 14 |  |
| A | PATENT ABSTRACTS OF JAPAN, vol, 12, no. 334 (P-756)[3181], 8 septembre 1988;<br>& JP-A-63 96 522 (TAIYO YUDEN) 27-04-1988<br>* Abrégé *<br>— — — | 1,5-8,14 |  |
| A | PATENT ABSTRACTS OF JAPAN, vol. 6, no. 116 (P-125)[994], 29 juin 1982;<br>& JP-A-57 45 420 (TOKYO DENKI KAGAKU KOGYO) 15-03-1982<br>* Abrégé *<br>— — — | 1,5,6,9,14 | DOMAINES TECHNIQUES RECHERCHES (Int. Cl.5)<br><br>G 01 J<br>H 01 L |
| A | PROCEEDINGS OF THE IEEE, vol. 66, no. 1, janvier 1978, pages 14-25; S.T. LIU et al.: "Pyroelectric detectors and materials"<br>* Page 20, colonne de gauche, section III: "Pyroelectric materials" *<br>— — — | 1,10 |  |
| A | PATENT ABSTRACTS OF JAPAN, vol. 11, no. 233 (P-600)[2680], 30 juillet 1987;<br>& JP-A-62 46 217 (MATSUSHITA) 28-02-1987<br>* Abrégé *<br>— — —<br>–/– | 1,18,19 |  |

Le présent rapport de recherche a été établi pour toutes les revendications

| Lieu de la recherche | Date d'achèvement de la recherche | Examinateur |
|---|---|---|
| La Haye | 02 avril 91 | THOMAS R.M. |

CATEGORIE DES DOCUMENTS CITES
X : particulièrement pertinent à lui seul
Y : particulièrement pertinent en combinaison avec un
   autre document de la même catégorie
A : arrière-plan technologique
O : divulgation non-écrite
P : document intercalaire
T : théorie ou principe à la base de l'invention

E : document de brevet antérieur, mais publié à la
   date de dépôt ou après cette date
D : cité dans la demande
L : cité pour d'autres raisons
................................................................
& : membre de la même famille, document
   correspondant

**Office européen
des brevets**

# RAPPORT DE RECHERCHE
# EUROPEENNE

Numéro de la demande

## EP 90 20 3409

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | PATENT ABSTRACTS OF JAPAN, vol. 12, no. 406 (P-777)[3253], 7 octobre 1988; & JP-A-144 222 (ATSUMI) 16-06-1988 * Abrégé * | 16,21 | |

- - - - -

DOMAINES TECHNIQUES
RECHERCHES (Int. Cl.5)

Le présent rapport de recherche a été établi pour toutes les revendications

| Lieu de la recherche | Date d'achèvement de la recherche | Examinateur |
|---|---|---|
| La Haye | 02 avril 91 | THOMAS R.M. |

CATEGORIE DES DOCUMENTS CITES
X : particulièrement pertinent à lui seul
Y : particulièrement pertinent en combinaison avec un autre document de la même catégorie
A : arrière-plan technologique
O : divulgation non-écrite
P : document intercalaire
T : théorie ou principe à la base de l'invention

E : document de brevet antérieur, mais publié à la date de dépôt ou après cette date
D : cité dans la demande
L : cité pour d'autres raisons

 

& : membre de la même famille, document correspondant